# EUROPÄISCHE PATENTSCHRIFT

(11) **EP 1 142 025 B1**
(45) Veröffentlichungstag und Bekanntmachung des Hinweises auf die Patenterteilung: **03.12.2008**
(21) Anmeldenummer: 99967868.3
(22) Anmeldetag: 08.12.1999
(51) Int. Cl.: H01L 29/06, H01L 29/73, H01L 29/739, H01L 29/74, H01L 29/78, H01L 29/861

(54) **LEISTUNGSHALBLEITERBAUELEMENT**
POWER SEMICONDUCTOR ELEMENT
COMPOSANT SEMI-CONDUCTEUR DE PUISSANCE

(30) Priorität: 18.12.1998 DE 19858762
(43) Veröffentlichungstag der Anmeldung: 10.10.2001
(73) Patentinhaber: Infineon Technologies AG, 81669 München (DE)
(72) Erfinder: STOISIEK, Michael, D-85521 Ottobrunn (DE)
(74) Vertreter: Viering, Jentschura & Partner
(86) Internationale Anmeldenummer: PCT/DE1999/003925
(87) Internationale Veröffentlichungsnummer: WO 2000/038242

(56) Entgegenhaltungen:
- EP-A- 0 604 194
- US-A- 5 003 372
- US-A- 5 113 237

## Beschreibung

Die vorliegende Erfindung betrifft ein Leistungshalbleiterbauelement mit einem pn-Übergang und einem zugehörigen Randabschluß.

Ein hochsperrender, in vertikaler Richtung eine zu sperrende Potentialdifferenz aufnehmender pn-Übergang, der sich nur über einen begrenzten Bereich eines Halbleiterkörpers, z. B. eines einkristallinen Siliziumsubstrates, ausdehnt (planarer pn-Übergang) benötigt zur Erlangung der Spannungsfestigkeit eine Randabschlußstruktur. Diese Randabschlußstruktur ist dafür vorgesehen, den Verlauf des elektrischen Feldes von einer vertikalen Ausrichtung im Mittenbereich des Bauelementes zu einem horizontalen Verlauf, d. h. parallel zu der Chipoberseite, im Randbereich zu drehen. Außerdem muß ein Bereich der Chipoberfläche vorhanden sein, in dem das elektrische Feld aus dem Chip in die Umgebung austreten kann. Die maximale Spannungsfestigkeit des pn-Überganges in dem ebenen mittleren Bereich, der für die eigentliche Spannungssperrung vorgesehen ist, sollte dabei möglichst wenig durch Effekte reduziert werden, die durch die Krümmung der Fläche des pn-Überganges am Rand hervorgerufen werden. Der Austrittsbereich des elektrischen Feldes aus dem Chip sollte außerdem möglichst klein sein. Mit bekannten Randabschlußkonstruktionen, die meistens aus einer geeigneten Kombination unterschiedlich dotierter Bereiche und darüber angeordneter leitender Feldplatten bestehen, läßt sich eine Breite des Austrittsbereiches, die durch den Quotienten aus geforderter Spannungsfestigkeit und Durchbruchfeldstärke des Siliziums (2*10⁵ V/cm) gegeben ist, grundsätzlich nicht unterschreiten. Derartige Randabschlüsse sind z. B. beschrieben in der US 4,672,738, der US 4,757,031 und der US 5,113,237.

EP 0 604 194 A2 offenbart ebenfalls einen Halbleiter, wobei sich ein Graben durch einen dotierten Bereich und einen pn-Übergang hindurch in den Halbleiter erstreckt.

Aufgabe der vorliegenden Erfindung ist es, ein für Leistungsanwendungen geeignetes Bauelement anzugeben, das einen Randabschluß eines pn-Überganges mit möglichst geringem Chipflächenbedarf besitzt.

Diese Aufgabe wird mit dem Bauelement mit den Merkmalen des Anspruches 1 gelöst. Eine Ausgestaltung ergibt sich aus dem abhängigen Anspruch.

Das erfindungsgemäße Bauelement besitzt eine Randstruktur mit der der Flächenbedarf für den Austritt des elektrischen Feldes an der Chipoberseite wesentlich geringer ist, als es die Durchbruchfeldstärke des Halbleitermateriales, insbesondere des Siliziums, erlauben würde. Dies wird dadurch erreicht, daß ein in den Halbleiterkörper eingelassenes Dielektrikum mit deutlich höherer Durchbruchfeldstärke als Silizium das elektrische Feld im Inneren des Halbleiterkörpers so ablenkt, daß die Äquipotentialflächen im wesentlichen vertikal zur Chipoberseite durch dieses Dielektrikum verlaufen. Das elektrische Feld wird daher von dem mittleren Bereich des Bauelementes, in dem die Äquipotentialflächen im wesentlichen koplanar zur Oberseite des Chips verlaufen, aus der vertikalen Richtung in eine horizontale Richtung bezüglich der Chipoberseite umgelenkt, was auf einer vergleichsweise kurzen Entfernung innerhalb des Dielektrikums geschieht. Im Austrittsbereich des elektrischen Feldes aus dem Chip befindet sich der wesentliche Teil des Feldes in dem Dielektrikum. Damit ist der Flächenbedarf im wesentlichen auf den Oberflächenbereich des Dielektrikums begrenzt.

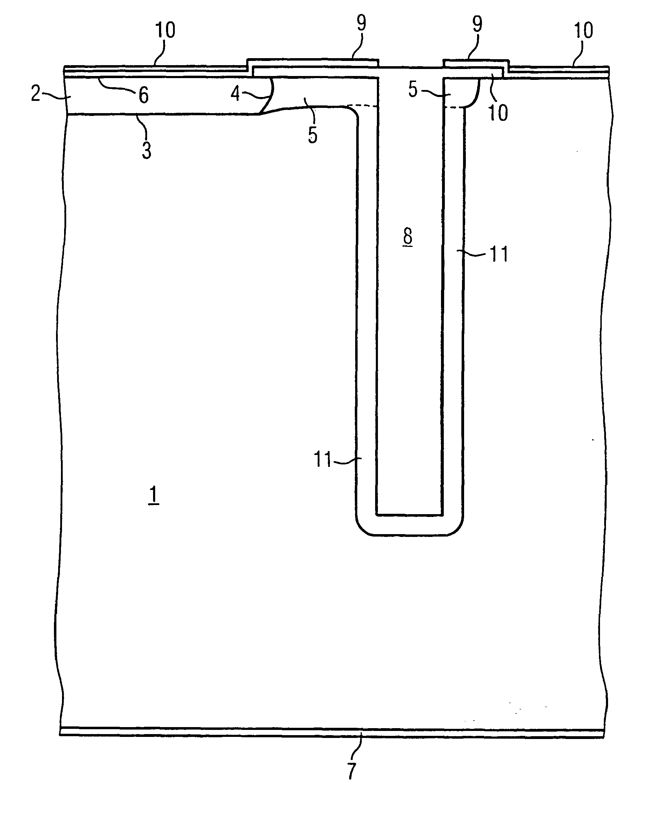

Es folgt eine genauere Beschreibung der erfindungsgemäßen Bauelemente anhand eines typischen Beispiels, das im Ausschnitt im Querschnitt in der Figur dargestellt ist.

In der Figur ist zur Vereinfachung der Darstellung ein Beispiel eines Bauelementes gezeigt, bei dem ein Halbleiterkörper 1, der mit einer Grunddotierung versehen ist, an einer Hauptseite einen dort ausgebildeten Bereich 2 aufweist, der zur Ausbildung eines pn-überganges 3 für elektrische Leitfähigkeit entgegengesetzten Vorzeichens zur Grunddotierung dotiert ist. Die Fläche des pn-Überganges 3 verläuft im wesentlichen koplanar zu der Ebene der oberen Hauptseite des Halbleiterkörpers. An den Rändern ist die Fläche des Bereiches 2 zu dieser Hauptseite hin gekrümmt, so daß zur Vertikalen hin gekrümmte Randflächen 4 des Bereiches 2 vorhanden sind, die einen Rand des Bereiches 2 darstellen. Bei dem erfindungsgemäßen Bauelement schließt sich daran auf der äußeren Seite des Bereiches 2 ein weiterer dotierter Bereich 5 an, der für elektrische Leitfähigkeit desselben Vorzeichens, aber mit einer geringeren Konzentration der Dotierstoffatome dotiert ist. Innerhalb des von diesem weiteren dotierten Bereich eingenommenen Bereiches ist ein dielektrischer Bereich 8 ausgebildet, der sich im wesentlichen senkrecht zu der Hauptseite des Halbleiterkörpers erstreckt. Dieser dielektrische Bereich 8 begrenzt den weiteren dotierten Bereich 5 und ragt so weit in den Bereich entgegengesetzt dotierten Halbleitermateriales, daß der gewünschte Effekt der Ablenkung des elektrischen Feldes erreicht wird. Um eine Spannung an das Bauelement anlegen zu können, sind Kontakte 6, 7 auf den beiden einander gegenüberliegenden Hauptseiten des Halbleiterkörpers aufgebracht. Die Ausgestaltung dieser Kontakte ist je nach Ausführungsbeispiel im Prinzip beliebig. Vorzugsweise wird der auf der mit dem pn-Übergang versehenen Hauptseite aufgebrachte Kontakt 6 über die den Randabschluß bildende Struktur hinausragend ausgebildet, so daß flächig ausgebildete elektrische Leiter 9, die elektrisch von dem weiteren dotierten Bereich 5, z. B. mittels einer dielektrischen Schicht 10, isoliert sind, als Feldplatten über diesem Bereich fungieren.

Der sperrende pn-Übergang 3 wird z. B. durch eine Diffusion von Dotierstoff in den Bereich 2 mit einer Eindringtiefe von ca. 3 µm und einer Randkonzentration von beispielsweise 10¹⁷ cm⁻³ in n-dotiertem Siliziumsubstrat mit einer homogenen Grunddotierung einer Konzentration von beispielsweise 4*10¹⁴cm⁻³ hergestellt. In lateraler Richtung erstreckt sich der pn-Übergang beispielsweise bis zu 7,5 µm weit Damit erhält man eine Durchbruchspannung des pn-Überganges in dem links eingezeichneten ebenen Anteil von ca. 500 V und eine Durchbruchspannung am Rand des pn-Überganges ohne die erfindungsgemäße Randabschlußstruktur von ca. 190 V.

Der dielektrische Bereich 8 kann z. B. hergestellt werden, indem in das Halbleitermaterial ein Graben geätzt wird. Dieser Graben wird mit einem dielektrischen Material, das auch für die dielektrische Schicht 10 an der Oberseite verwendet werden kann, aufgefüllt. Als Füllung des Grabens kann ein dielektrisches Material verwendet werden, dessen relative Dielektrizitätskonstante kleiner als die von Silizium ist und dessen Durchbruchfeldstärke größer als die von Silizium ist, beispielsweise Polyimid. Bei Verwendung eines Halbleiterkörpers aus Silizium besteht auch die Möglichkeit, den Graben mit Hilfe thermischer Oxidation des Siliziums zu SiO₂ zu füllen. Das bei der Oxidation entstehende Siliziumoxid nimmt ein größeres Volumen ein als das oxidierte Silizium. Vorzugsweise wird der Graben nicht vollständig mit dem thermischen Oxid gefüllt, um mechanische Spannungen zu vermeiden. Ein restliches Volumen des Grabens wird durch Einbringen eines dielektrischen Materiales aufgefüllt.

Vorzugsweise werden die als Feldplatten fungierenden flächig ausgebildeten elektrischen Leiter 9, die gegebenenfalls vorhanden sein können, um die Verteilung des elektrischen Feldes in dem Halbleitermaterial entsprechend der gewünschten Form zu beeinflussen, auf etwa 1 µm dickem Oxid außerhalb des von dem dielektrischen Bereich an der Oberfläche eingenommenen Bereiches ausgebildet. Bei spannungsbelastetem pn-Übergang im Betrieb des Bauelementes verlaufen die Äquipotentialflächen vom ungestörten Bereich, der in der Figur links dargestellt ist, herkommend zunächst in horizontaler Richtung bezüglich der Chipoberseite auf den dielektrischen Bereich 8 zu. Die Äquipotentialflächen sind in der Nähe des dielektrischen Bereiches 8 bereits etwas zur oberen Hauptseite des Halbleiterkörpers hin gekrümmt. Wegen der unterschiedlichen Dielektrizitätskonstanten des dielektrischen Materiales in dem dielektrischen Bereich 8 und des umgebenden Halbleitermateriales (z. B. SiO₂ bzw. Si) werden die Äquipotentialflächen innerhalb des dielektrischen Bereiches 8 zur Oberfläche des Chips hin abgelenkt und befinden sich fast alle innerhalb des dielektrischen Bereiches, wenn sie aus der Chipoberfläche austreten. Das in der Figur weiter rechts eingezeichnete Halbleitermaterial wird daher von dem dielektrischen Bereich 8 weitgehend gegenüber dem elektrischen Feld abgeschirmt.

Die Wirkung des dielektrischen Bereiches 8, der das elektrische Feld zur Chipoberfläche hin ablenkt, wird zusätzlich dadurch unterstützt, daß sich angrenzend an den dielektrischen Bereich 8 auf der von dem pn-Übergang 3 abgewandten Seite in dem Halbleitermaterial eine Inversionsladungsschicht ausbildet, die einen Austritt der Äquipotentiallinien in diesem Teil des Bauelementes verhindert. Damit auch bei schnellen Schaltvorgängen einer an das Bauelement angelegten Spannung die notwendigen Inversionsladungsträger bereitstehen, ist der weitere dotierte Bereich 5 vorzugsweise auch auf der von dem pn-Übergang abgewandten Seite des dielektrischen Bereiches 8 ausgebildet. Dazu ist in der Figur auf der rechten Seite des dielektrischen Bereiches 8 ein Anteil des weiteren dotierten Bereiches 5 eingezeichnet.

Wesentlich für die Funktionsweise der erfindungsgemäßen Bauelementstruktur ist, daß der Bereich, in dem das elektrische Feld aus dem Halbleitermaterial in das dielektrische Material des dielektrischen Bereiches 8 übertritt, so groß ist, daß dort die Durchbruchsfeldstärke des Siliziums nicht überschritten wird. Daher befindet sich um den dielektrischen Bereich 8 herum in dem daran angrenzenden Halbleitermaterial eine dünne Zone 11, die für elektrische Leitfähigkeit desselben Vorzeichens wie der weitere dotierte Bereich 5 dotiert ist. Eine solche Zone läßt sich z. B. durch eine Diffusion von Dotierstoffatomen aus dem noch nicht gefüllten Graben in das umliegende Halbleitermaterial hinein herstellen. Erst nachdem diese Zone 11 ausgebildet ist, wird der Graben mit dem vorgesehenen dielektrischen Material aufgefüllt. So hat man die zusätzliche Möglichkeit, die Größe des Eintrittsbereiches des elektrischen Feldes aus dem Halbleitermaterial in das dielektrische Material einzustellen und die erfindungsgemäße Randstruktur optimal zu dimensionieren. Die senkrecht zu der Grenzfläche des dielektrischen Bereiches 8 integrierte Konzentration an Dotierstoffatomen in der Zone 11 darf nirgends den Wert von 10¹² cm⁻² wesentlich überschreiten.

Die vorgeschlagene Randabschlußstruktur für den pn-Übergang ist grundsätzlich für alle Halbleiterbauelemente mit einem planaren hochsperrenden pn-Übergang einsetzbar wie z. B. für Dioden, Bipolartransistoren, Leistungs-MOS-Transistoren, IGBT und Thyristoren.

## Patentansprüche

1. Bauelement mit einem Halbleiterkörper mit einer Hauptseite und mit einem pn-Übergang (3) zwischen dotierten Bereichen (1, 2),
bei dem der pn-Übergang (3) einen Anteil einer zu der Hauptseite parallelen Ebene einnimmt und der dotierte Bereich (2), der auf der der Hauptseite zugewandten Seite des pn-Übergangs (3) angeordnet ist, Randflächen (4) aufweist, die zu einer Oberfläche der Hauptseite hin verlaufen,
bei dem dieser dotierte Bereich (2) seitlich von einem weiteren dotierten Bereich (5) umgeben ist, der dasselbe Vorzeichen der elektrischen Leitfähigkeit mit einer geringeren Dotierungskonzentration aufweist,
bei dem in diesem weiteren Bereich (5) und bis in den Bereich auf der der Hauptseite abgewandten Seite des pn-Übergangs (3) hineinreichend ein dielektrischer Bereich (8) vorhanden ist, der im wesentlichen senkrecht zur Hauptseite ausgerichtet ist, wobei der dielektrische Bereich (8) von einer Zone (11) umgeben ist, die für eine elektrische Leitfähigkeit desselben Vorzeichens wie diejenige des weiteren dotierten Bereichs (5) dotiert ist, und
bei dem die Zone (11) eine Dotierungskonzentration aufweist, deren Integral in Richtung senkrecht zu einer Begrenzungsfläche des dielektrischen Bereiches (8) höchstens 10¹² cm⁻² beträgt.

2. Bauelement nach Anspruch 1,
bei dem auf der Oberfläche der Hauptseite flächig ausgebildete elektrische Leiter vorhanden sind, die mindestens einen Anteil des weiteren dotierten Bereiches (5) überdecken und davon elektrisch isoliert sind.

## Claims

1. A component having a semiconductor body having a main side and having a pn junction (3) between doped regions (1, 2),
in which the pn junction (3) occupies a portion of a plane that is in parallel to the main side, and the doped region (2) which is arranged on that side of the pn junction (3) which faces the main side has edge surfaces (4) which run toward a surface of the main side,
in which said doped region (2) is laterally surrounded by a further doped region (5) which has the same sign of electrical conductivity with a lower doping concentration,
in which in said further region (5) and reaching into the region on that side of the pn junction (3) which is opposite to the main side, a dielectric region (8) is provided which is oriented essentially perpendicularly to the main side,
wherein the dielectric region (8) is surrounded by a zone (11) doped for electrical conductivity of the same sign as that of the further doped region (5), and
in which the zone (11) has a doping concentration whose integral in the direction perpendicularly to a bounding surface of the dielectric region (8) is at most 10¹² cm⁻².

2. Component according to claim 1,
in which electrical conductors of planar construction are provided on the surface of the main side, said conductors covering at least a portion of the further doped region (5) and being electrically insulated from the same.

## Revendications

1. Composant comprenant un corps de semi-conducteur ayant une face principale et une jonction (3) pn entre des régions (1, 2) dopées,
dans lequel la jonction (3) pn occupe une partie d'un plan parallèle à la face principale et la région (2) dopée, qui est disposée du côté de la jonction (3) pn tourné vers la face principale, a des surfaces (4) de bord, qui s'étendent vers une surface de la face principale,
dans lequel cette région (2) dopée est entourée latéralement d'une autre région (5) dopée qui a le même signe de la conductivité électrique tout en ayant une concentration de dopage plus petite,
dans lequel dans cette autre région (5) et en allant jusqu'à la partie du côté de la jonction (3) pn éloignée de la face principale, il y a une région (8) diélectrique qui est dirigée sensiblement perpendiculairement à la face principale, la région (8) diélectrique étant entourée d'une zone (11) qui est dopée pour une conductivité électrique du même signe que celle de l'autre région (5) dopée,
dans lequel la zone (11) a une concentration de dopage, dont l'intégrale, dans la direction perpendiculaire a une surface de démarcation de la zone (8) diélectrique, s'élève au plus à 10¹² cm⁻².

2. Composant suivant la revendication 1, dans lequel il y a sur la surface de la face principale des conducteurs électriques de constitution plate, qui recouvrent au moins une partie de l'autre région (5) dopée et qui en sont isolés électriquement.
